# EUROPEAN PATENT APPLICATION

(11) **EP 4 235 303 A1**
(43) Date of publication of application: **30.08.2023**
(21) Application number: 21891449.7
(22) Date of filing: 23.08.2021
(51) Int. Cl.: G03F 7/20, H05G 2/00

(54) **FOIL TRAP COVER DEVICE AND DEBRIS REDUCTION APPARATUS**

(30) Priority: 11.11.2020 JP 2020187908
(71) Applicant: Ushio Denki Kabushiki Kaisha, Tokyo 100-8150 (JP)
(72) Inventor: YABUTA Hironobu, Tokyo 100-8150 (JP)
(74) Representative: Tomerius, Isabel
(86) International application number: PCT/JP2021/030808
(87) International publication number: WO 2022/102201

(57) **Abstract**

Disclosed are a foil trap cover device capable of inhibiting the occurrence of a failure of a heating unit caused by debris, and a debris reduction machine equipped with the foil trap cover device. The foil trap cover device surrounds the outer periphery of a rotary foil trap and collects debris scattered from the rotary foil trap. The rotary foil trap has a plurality of rotating foils and is arranged near a plasma, which is generated by a plasma generation unit. The rotary foil trap passes light emitted from the plasma and captures debris generated from the plasma. The foil trap cover device includes a cover body that surrounds the outer periphery of the rotary foil trap, and a cover heating unit that is provided to at least a part of a second surface of the cover body to heat the cover body. The second surface faces the plasma and is opposite to a first surface facing the foils. The foil trap cover device also includes a heating unit protection member that covers the cover heating unit.

## Description

### TECHNICAL FIELD

The present invention relates to a foil trap cover device arranged to surround a rotary foil trap that captures debris emitted from a high-temperature plasma, and also relates to a debris reduction apparatus that includes the foil trap cover device.

### BACKGROUND ART

In recent years, as downsizing and high integration are required to semiconductor integrated circuits, the wavelength of light sources for exposure becomes shorter. Next-generation light sources for semiconductor-exposure are studied, e.g., an extreme ultraviolet light (hereinafter referred to as "EUV (Extreme Ultraviolet) light") source device that emits light at the wavelength of 13.5 nm is studied.

Several methods for generating EUV radiation in an EUV light source device are known. One of the methods is a method in which a high-temperature plasma is generated by heating and exciting species of extreme ultraviolet light emission (hereinafter, occasionally referred to as "EUV emitting species"), and EUV light is extracted from the high-temperature plasma.

EUV light source apparatuses employing such methods are classified into an LPP (Laser Produced Plasma) type and a DPP (Discharge Produced Plasma) type, based on a method of generating a high-temperature plasma.

A DPP type EUV light source device applies a high voltage across a gap between electrodes, which are supplied with a discharge gas containing EUV radiation species (gas-phase plasma material), to trigger discharging and generate a high-density high-temperature plasma. Then, the DPP type EUV light source device utilizes extreme ultraviolet light emitted from the high-density high-temperature plasma. One method for the DPP type EUV light source device is described in, for example, Patent Literature Document 1 (JP 2017-219698A), i.e., a method has been proposed in which a liquid high-temperature plasma material (e.g., Sn (tin)) is supplied to an electrode surface for generating a discharge, the plasma material is vaporized by irradiating the plasma material with an energy beam such as a laser beam, and then a high-temperature plasma is generated by the discharge. Such a scheme is sometimes referred to as an LDP (Laser Assisted Discharge Plasma) scheme.

An EUV light source device is used as a light source device for a lithographic apparatus that is used to manufacture semiconductor devices. Alternatively, an EUV light source device is used as a light source device for an apparatus that is used to inspect a mask in a lithography process. That is, the EUV light source device is used as a light source device of another optical device that uses an EUV beam (EUV-utilizing device).

Since an EUV beam tends to be attenuated in the atmosphere, the plasma to the EUV-utilizing device are placed in a reduced-pressure atmosphere, that is, in a vacuum environment.

On the other hand, debris flies and spreads at high speed from the plasma generated by LDP method. The debris includes particles of a high-temperature plasma material (tin particles when the plasma material is tin), and particles of materials of a discharge electrode which are sputtered upon generation of the plasma. When debris reaches the EUV-utilizing device, it may damage or contaminate a reflective film of an optical element in the EUV-utilizing device and degrade performance of the EUV-utilizing device. To address this problem, proposed is a debris reduction device (DMT (Debris Mitigation Tool) that captures the spreading debris so that the debris does not enter the EUV-utilizing device. See Patent Literature Document 1 (JP-2017-219698A)).

The debris reduction device includes a foil trap having a plurality of foils (thin films or thin plates) arranged to finely divide the space in the foil trap.

Each of the spaces finely divided by the foils has a function of lowering the conductance in the space and increasing the pressure in the space. As debris travels through each space divided by the foils (the area where the pressure is increased), the probability of collision between the debris and the atmosphere gas in the area where the pressure is increased is increased. As a result, the flying (scattering) speed of the debris is reduced and the direction of travel of the debris changes, and therefore debris is trapped in the debris reduction device.

There are two types of foil trap, i.e., a static foil trap in which a plurality of foils are fixed in position, and a rotary foil trap in which a plurality of foils can actively (dynamically) collide with debris. The rotary foil trap includes a plurality of foils arranged about a center axis of rotation. The foils extend radially from the center axis of rotation. Rotation of the foils about the axis of rotation causes debris flying from the plasma to collide with the foils. It should be noted that a single debris reduction device may include both a rotary foil trap and a static foil trap, or may include only one of them.

A portion of the debris that has collided with the foils (blades) is deposited on the foils. The foils of the rotary foil trap are heated by radiation from the plasma and can be maintained above the melting point (about 232 degrees C) of the debris or tin if appropriate heat removal is applied to the debris (tin). Thus, no debris continues to deposit on the foils. Liquid debris on the foils is moved over the foils by the centrifugal force generated upon the rotation of the foils and eventually removed from the ends of the foils to the outside of the rotary foil trap.

The rotary foil trap is surrounded by a cover member that has an opening. The opening is designed not to block EUV radiation. The cover member collects debris that has been removed from the ends of the foils of the rotary foil trap by a centrifugal force.

### LISTING OF REFERENCES

### PATENT LITERATURE DOCUMENTS

Patent Literature Document 1: JP 2017-219698A

### SUMMARY OF THE INVENTION

### PROBLEMS TO BE SOLVED BY THE INVENTION

The cover member is provided with a heating unit for heating the cover member in order to prevent the debris (e.g., tin) collected by the cover member from solidifying.

Debris removed from the ends of the foils of the rotary foil trap is deposited on the inner surface of the cover member surrounding the outer periphery of the rotary foil trap. Specifically, most of the debris is deposited on the surface on an imaginary extension line of the centrifugal force occurring in the rotary foil trap. Liquid tin has the property of chemically reacting with a solid metal to dissolve the solid metal. The reaction rate (dissolution rate) increases with temperature. Thus, if the heating unit is provided on the inner surface of the cover member, debris (tin) comes into contact with the heating unit which is supplied with power and has a high temperature, so that the heating unit itself is dissolved (corroded). To avoid this, the heating unit is provided on the outer surface of the cover member such that the heating unit can avoid direct contact with the liquid tin.

However, even if the heating unit is disposed on the outer surface of the cover member as described above, a defect such as a disconnection may occur in a part of the heating unit as an EUV light source device is operated to some extent. This is considered to be because, when EUV light source device is in operation, a part of tin flying from the plasma and/or tin floating in the chamber reaches the heating unit, and an quantity of the tin gradually increases such that the heating unit that is supplied with power and has a high temperature is corroded by the tin.

An object of the present invention is to provide a foil trap cover device that surrounds a rotary foil trap configured to capture debris generated from plasma, and that is capable of suppressing occurrence of a defect in a heating unit, which would otherwise be caused by debris, and another object of the present invention is to provide a debris reduction device including the foil trap cover device.

### SOLUTION TO THE PROBLEMS

In order to solve the above-described problems, a foil trap cover device according to one aspect of the present invention is directed to a foil trap cover device configured to surround an outer peripheral portion of a rotary foil trap and collect debris scattered from the rotary foil trap. The rotary foil trap is arranged near a plasma generated by a plasma generating unit. The rotary foil trap has a plurality of rotatable foils and allows light emitted from the plasma to pass through the rotary foil trap. The rotary foil trap captures debris generated from the plasma. The foil trap cover device includes a cover body configured to surround the outer peripheral portion of the rotary foil trap. The cover body has a first surface, which faces the foils, and a second surface, which is opposite to the first surface and is exposed to the plasma. The foil trap cover device also includes a cover heating unit provided on at least a portion of the second surface of the cover body and configured to heat the cover body. The foil trap cover device also includes a heating unit protecting member configured to cover the cover heating unit.

In this foil trap cover device, since the cover heating unit provided on the second surface of the cover body facing the plasma is covered with the heating unit protecting member, debris flying from the plasma and debris floating in a chamber in which the foil trap cover device is installed can be appropriately prevented from reaching the surface of the cover heating unit. Thus, corrosion of the cover heating unit due to debris can be suppressed, and occurrence of defects such as disconnection can be appropriately suppressed. Therefore, it is possible to bring the life of the cover heating unit (time until a defect caused by corrosion derived from debris occurs) close to the original life of the cover heating unit (the time until a defect caused by reasons not related to corrosion derived from debris occurs). Further, if the heating unit protecting member is a plate-like member having a certain thickness, it is possible to suppress the transfer of the heat of the cover heating unit to the surface of the heating unit protecting member (the surface opposite to the surface facing the cover heating unit). Accordingly, it is possible to suppress the surface temperature of the heating unit protecting member from becoming a high temperature state, and to suppress a reaction rate between the heating unit protecting member and the debris.

In the above-described foil trap cover device, the heating unit protecting member may be made from a corrosion resistant material having a higher corrosion resistance to the debris than the cover heating unit.

In this configuration, since the corrosion resistance of the heating unit protecting member against debris is higher than that of the cover heating unit, the life of the heating unit protecting member (time until the above-described function of the heating unit protecting member is impaired due to corrosion caused by debris) can be made longer than the life of the cover heating unit that does not have the heating unit protecting member.

In the above-described foil trap cover device, the cover heating unit may be sealed by the cover body and the heating unit protecting member.

In this configuration, it is possible to reliably prevent the debris from adhering to the cover heating unit in a high temperature state.

In the above-described foil trap cover device, the heating unit protecting member may be attached to the second surface of the cover body by welding.

In this configuration, the cover heating unit can be appropriately sealed by the cover body and the heating unit protecting member.

In the above-described foil trap cover device, a corrosion resistant film having corrosion resistance against the debris may be provided on at least a part of an exposed surface of the heating unit protecting member.

In this configuration, even when debris adheres to the heating unit protecting member in a high temperature state due to radiation from the plasma, it is possible to suppress the occurrence of corrosion of the heating unit protecting member.

In the above-described foil trap cover device, the corrosion resistant film may be a film made of at least one of tungsten, molybdenum, titanium nitride, and silicon carbide, or an oxide film.

In this configuration, even when debris adheres to the heating unit protecting member in a high temperature state due to radiation from the plasma, it is possible to appropriately suppress the occurrence of corrosion in the heating unit protecting member.

In the above-described foil trap cover device, the cover body and the heating unit protecting member may be made of the same material. In this configuration, the thermal expansion coefficient of the cover body and the thermal expansion coefficient of the heating unit protecting member can be made the same. Thus, the influence of the unwanted stress due to the difference in the thermal expansion coefficient is eliminated, and it is possible to suppress the occurrence of defects such as occurrence of gaps and breakage.

In the above-described foil trap cover device, the cover body and the heating unit protecting member may be made of stainless steel. In this configuration, it is advantageous in terms of heat resistance, processability, and cost efficiency.

In the above-described foil trap cover device, the cover heating unit may have a plurality of cover heating sub-units such that an amount of electric power to be supplied to each of the cover heating sub-units can individually be controlled. The cover heating sub-units may be divided into a plurality of groups, and these groups are located in a plurality of regions, respectively. The foil trap cover device may further include a temperature detecting unit configured to detect a plurality of temperature of the cover body for the plurality of regions, respectively. The foil trap cover device may further include a control unit configured to control the amount of electric power to be supplied to each group of the cover heating sub-units based on the temperatures detected by the temperature detecting unit so that the temperatures of the cover body become equal to or higher than a melting point of a raw material used to generate the plasma.

In this configuration, the temperature of each region of the cover body can be maintained at or above the melting point of the plasma raw material. Therefore, the collected debris is not solidified, and the liquid phase state of the debris can be appropriately maintained.

In the above-described foil trap cover device, the regions may be defined by dividing the second surface according to a distance from the plasma. The groups of cover heating sub-units in the regions may be independent from each other depending upon the regions.

In this configuration, appropriate power supply control can be performed in consideration of a fact that the degree of heating should be different depending on the distance from the plasma.

According to another aspect of the present invention, there is provided a debris reduction device that includes any of the above-described foil trap cover devices and the rotary foil trap. In this configuration, the debris reduction device includes the foil trap cover device in which occurrence of a defect in the heating unit (cover heaters) due to debris is suppressed.

According to still another aspect of the present invention, there is provided an extreme ultraviolet light source device that includes the above-described debris reduction device and the plasma generation unit that generates the plasma such that the plasma emits the extreme ultraviolet light. In this configuration, the extreme ultraviolet light source device includes the debris reduction device in which occurrence of a defect of the heating unit (cover heaters) due to debris in the foil trap cover device is suppressed.

### ADVANTAGEOUS EFFECTS OF THE INVENTION

The foil trap cover device of the present invention is a foil trap cover device that surrounds a rotary foil trap configured to capture debris generated from plasma, and can suppress occurrence of a defect in a heating unit due to debris.

These and other objects, aspects, and advantages of the present invention may be understood by those skilled in the art from the following detailed description of embodiments of the invention (detailed description of the invention) when read in conjunction with the accompanying drawings and the claims.

### BRIEF DESCRIPTION OF THE DRAWINGS

FIG. 1 is a schematic diagram illustrating an extreme ultraviolet light source device according to an embodiment of the invention.
FIG. 2 is a side cross-sectional view illustrating a part of the extreme ultraviolet light source device.
FIG. 3 is a front view of a rotary foil trap.
FIG. 4 is a top view of foils of a static foil trap.
FIG. 5 is a front view of the static foil trap.
FIG. 6 is a schematic view illustrating a configuration of a cover member.
FIG. 7 is an enlarged view of a cover heating unit.
FIG. 8 is a front view of the cover heating unit.
FIG. 9 is a front view of the cover member.
FIG. 10 is a diagram useful to describe individual control to a plurality of cover heating sub-units.
FIG. 11 illustrates a control system of the cover heating sub-units.
FIG. 12 is a conceptual diagram of the individual control to the cover heating sub-units.

### DESCRIPTION OF EMBODIMENTS

Hereinafter, embodiments of the present invention will be described in detail with reference to the accompanying drawings. It should be noted that the following embodiments are not intended to limit the present invention, and not all combinations of features described in the embodiments are essential to the configuration of the present invention. The configuration of the embodiment may be appropriately modified and/or changed depending on the specifications and various conditions (use conditions, use environment, and the like) of the device to which the present invention is applied. The technical scope of the present invention is defined by the claims, and is not limited by the following individual embodiments. In addition, the drawings used in the following description may differ from actual structures in scale, shape, and the like in order to make each configuration easy to understand.

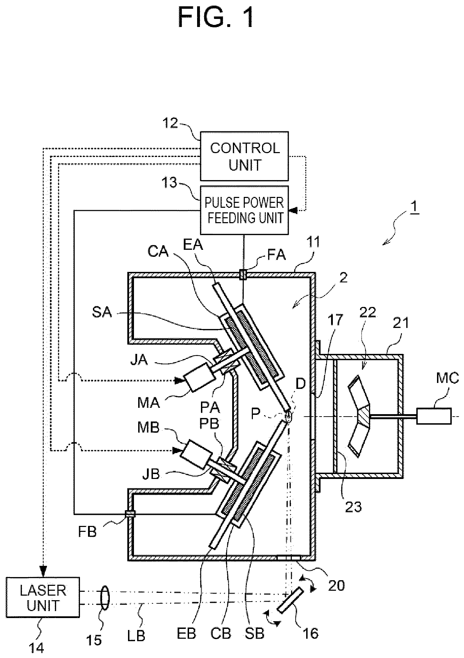

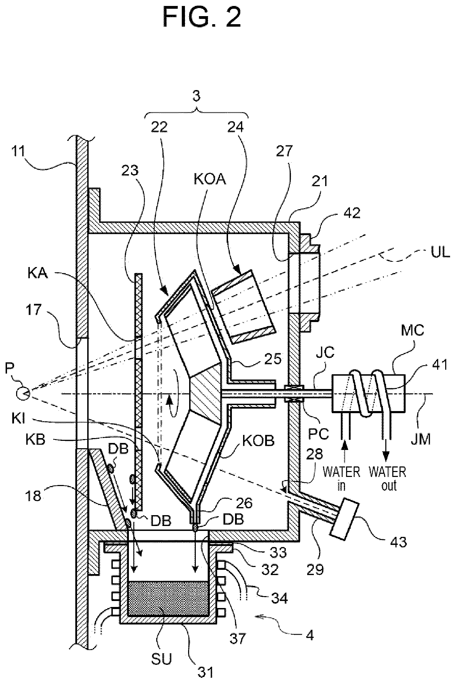

FIG. 1 is a cross-sectional view illustrating the inside of a chamber and a connection chamber of an extreme ultraviolet light source device according to an embodiment of the invention, taken along a horizontal direction, and FIG. 2 is a cross-sectional view illustrating a schematic configuration of a debris reduction unit and a debris accommodation unit according to the embodiment. In this embodiment, an LDP type extreme ultraviolet light source device (EUV light source device) will be described.

In FIG. 1, the EUV light source device 1 emits extreme ultraviolet light (EUV light). The wavelength of the extreme ultraviolet light is, for example, 13.5 nm.

Specifically, the EUV light source device 1 irradiates a liquid-phase plasma source (plasma material) SA, SB, which is supplied to the respective surfaces of a pair of discharge electrodes configured to generate a discharge, with an energy beam such as a laser beam LB to vaporize the plasma source SA, SB. Thereafter, the plasma P is generated upon discharging in a discharge region D between the discharge electrodes EA and EB. EUV beam is emitted from the plasma P.

The EUV light source device 1 may be used, for example, as a light source device of a lithographic apparatus in semiconductor device manufacturing or a light source device of a mask inspection device in lithography. For example, when the EUV light source device 1 is used as the light source device for a mask inspection device, a part of EUV beam emitted from the plasma P is extracted and guided to the mask inspection device. The mask inspection device performs blank inspection or pattern inspection of the mask using EUV beam emitted from the EUV light source device 1 as inspection light. By using the EUV beam, it is possible to cope with processing from 5 nm to 7 nm. The EUV beam extracted from the EUV light source device 1 is defined (shaped) by an opening KA provided in a heat shield plate 23 shown in FIG. 2.

As illustrated in FIGS. 1 and 2, the EUV light source device 1 includes a light source unit 2, a debris reduction unit 3, and a debris accommodation unit 4. The light source unit 2 generates an EUV beam based on an LDP method. The debris reduction unit 3 is a debris reduction device that captures debris scattered together with the EUV beam emitted from the light source unit 2. The debris accommodation unit 4 receives debris generated in the light source unit 2, debris captured by the debris reduction unit 3, and other debris.

The EUV light source device 1 also includes a chamber 11 that isolates the plasma P generated in the device 1 from the outside. The chamber 11 is a rigid body, which is formed from, for example, metal. The chamber 11 is a vacuum housing, and the inside thereof is brought into a reduced-pressure atmosphere in order to satisfactorily generate discharging for heating and exciting the plasma source SA, SB and suppress the attenuation of the EUV beam.

The light source unit 2 is arranged inside the chamber 11. The light source unit 2 includes a pair of discharge electrodes EA and EB. The discharge electrodes EA and EB have the same shape and the same size. Each of the electrodes EA and EB is a disk-shaped member. For example, the discharge electrode EA is used as a cathode, and the discharge electrode EB is used as an anode. The discharge electrode EA, EB is formed of a refractory metal (metal having a high melting point) such as molybdenum (Mo), tungsten (W), or tantalum (Ta). The discharge electrodes EA and EB are disposed at positions spaced apart from each other, but the peripheral portions of the discharge electrodes EA and EB are close to each other. A discharge region D in which the plasma P is generated is located in a gap between the discharge electrodes EA and EB in which the peripheral portions of the discharge electrodes EA and EB are closest to each other.

As electric power is supplied to the discharge electrodes EA and EB from a pulsed electric power supplying unit 13, discharging takes place in the discharge region D. Then, an electric current flowing between the discharge electrodes EA and EB during the discharging heats and excites the plasma source SA, SB transported to the discharge region D upon rotations of the discharge electrodes EA and EB, and the plasma P that emits the EUV beam is generated.

The discharge electrode EA is connected to a rotation shaft JA of a motor MA such that the discharge electrode EA rotates about a rotation axis of the discharge electrode EA. The discharge electrode EB is connected to a rotation shaft JB of a motor MB such that the discharge electrode EB rotates about a rotation axis of the discharge electrode EB. The motors MA and MB are disposed outside the chamber 11. The rotating shaft JA, JB of the motor MA, MB extends into the inside of the chamber 11 from the outside of the chamber 11. A gap between the rotating shaft JA and a wall of the chamber 11 is sealed with a seal member PA, and a gap between the rotating shaft JB and the wall of the chamber 11 is sealed with a seal member PB. Each of the seal members PA and PB is, for example, a mechanical seal. The seal members PA and PB support the shafts JA and JB such that the shaft JA and JB can rotate, respectively, while maintaining the reduced pressure in the chamber 11.

In this way, the discharge electrodes EA and EB are driven by the respective motors MA and MB via the rotating shafts JA and JB. The rotational drive of each of the motors MA and MB is controlled by a control unit 12.

Inside the chamber 11, arranged are a container CA in which a liquid-phase plasma source SA is stored and another container CB in which a liquid-phase plasma source SB is stored. The containers CA and CB are supplied with heated liquid-phase plasma-source SA and SB, respectively. The liquid-phase plasma-source SA, SB is, for example, tin.

The container CA contains the plasma source SA such that the lower part of the discharge electrode EA is immersed in the plasma source SA in the liquid phase. The container CB contains the plasma source SB such that the lower part of the discharge electrode EB is immersed in the plasma source SB in the liquid phase. Therefore, a liquid-phase plasma-source SA, SB adheres to the lower part of the discharge-electrode EA, EB. As the discharge electrode EA, EB rotates, the liquid-phase plasma source SA, SB present on the lower part of the discharge electrode EA, EB is transported to the discharge region D where the plasma P is generated.

A laser source (energy beam irradiation device) 14 is disposed outside the chamber 11. The laser source or laser unit 14 irradiates the plasma source SA, which is present on the discharge electrode EA transported to the discharge region D, with an energy beam to vaporize the plasma source SA. The laser unit14 is, for example, an Nd:YVO₄ (Neodymium-doped Yttrium Orthovanadate) laser device. The laser unit 14 emits a laser beam LB in the infrared range of the wavelength 1064 nm. It should be noted, however, that the energy beam irradiation device may be any suitable device that emits an energy beam other than the laser beam LB as long as the energy beam irradiation device can vaporize the plasma source SA.

Timing of emission of the laser beam LB from the laser unit 14 is controlled by the control unit 12. The laser beam LB emitted from the laser unit 14 is guided to a movable mirror 16 via, for example, a condensing module (focusing module) including a condenser lens 15. The focusing module adjusts a spot diameter of the laser beam LB at the laser beam irradiation position of the discharge electrode EA. The condenser lens 15 and the movable mirror 16 are arranged outside the chamber 11.

The laser beam LB condensed by the condenser lens 15 is reflected by the movable mirror 16 such that the laser beam LB passes through a transparent window 20 provided on the wall of the chamber 11, and reaches the peripheral edge of the discharge electrode EA in the vicinity of the discharge region D.

The emission position of the infrared laser beam LB on the discharge electrode EA can be adjusted by changing the orientation or posture of the movable mirror 16. The orientation of the movable mirror 16 may be adjusted manually by an operator. Alternatively, the control unit 12 may adjust the orientation of the movable mirror 16 based on information of the intensity of the EUV beam supplied from a monitoring device 43 which will be described later. If the control unit 12 is configured to adjust the orientation of the movable mirror 16, the movable mirror 16 is driven by a movable mirror driving unit (not shown).

In order to facilitate the irradiation of the laser beam LB to the peripheral edge of the discharge electrode EA in and near the discharge region D, the rotation axes of the discharge electrode EA and EB are not parallel to each other. The distance between the rotating shafts JA and JB is narrower on the motor MA, MB side and wider on the discharge electrode EA, EB side. Thus, the facing surfaces of the discharge electrodes EA and EB are brought close to each other whereas the opposite surfaces of the discharge electrodes EA and EB are retracted from the irradiation path of the laser beam LB. Accordingly, it is possible to easily irradiate the peripheral portion of the discharge electrode EA in and near the discharge region D with the laser beam LB.

The discharge electrode EB is disposed between the discharge electrode EA and the movable mirror 16. The laser beam LB reflected by the movable mirror 16 passes through the vicinity of the outer peripheral surface of the discharge electrode EB, and then reaches the outer peripheral surface of the discharge electrode EA. At this time, the discharge electrode EB is retracted toward the motor MB (to the left in FIG. 1) than the discharge electrode EA so that the laser beam LB is not blocked by the discharge electrode EB.

The liquid-phase plasma source SA that has adhered to the outer peripheral surface of the discharge electrode EA in the vicinity of the discharge region D is vaporized by being irradiated with the laser beam LB, and is supplied to the discharge region D as a gas-phase plasma source SA.

In order to generate the plasma P in the discharge region D (in order to convert the plasma source SA of the gas phase into a plasma), the pulsed power supply unit 13 supplies power to the discharge electrodes EA and EB. When the gas-phase plasma source SA is supplied to the discharge region D upon irradiation of the laser beam LB, discharging takes place between the discharge electrodes EA and EB in the discharge region D. At this time, the pulsed power supply unit 13 periodically supplies the pulsed power to the discharge electrodes EA and EB.

The pulsed power supply unit 13 is disposed outside the chamber 11. Electricity feed lines that extend from the pulsed power supply unit 13 pass through feedthrough parts FA and FB, respectively, and extend into the interior of the chamber 11. The feedthrough parts FA and FB are sealing members that are embedded in the wall of the chamber 11, respectively, and maintain a reduced pressure atmosphere in the chamber 11. The operation of the laser unit 14 for generating the plasma P and the operation of the pulsed power supply unit 13 are controlled by the control unit 12, respectively.

The two electricity-feed lines extending from the pulsed power supply unit 13 are connected to the containers CA and CB via the feedthrough parts FA and FB, respectively. Each of the containers CA and CB is formed of a conductive material. The plasma sources SA and SB contained in the containers CA and CB, respectively, are also a conductive material such as tin. A lower portion of the discharge electrode EA, EB is immersed in the plasma source SA, SB accommodated in the respective container CA, CB. Therefore, when the pulsed power is supplied from the pulsed power supply unit 13 to the container CA, CB, the pulsed power is supplied to the discharge electrode EA, EB via the plasma source SA, SB. When discharging occurs between the discharge electrodes EA and EB, the gas-phase plasma material SA in the discharge region D is heated and excited by an electric current to generate the plasma P.

EUV beam is emitted from the plasma P. The EUV beam is used in an EUV-utilizing device (a lithographic device or a mask inspection device) which is another optical device. In this embodiment, the EUV beam is used in the mask inspection device.

A connection chamber 21 is arranged between the chamber and the EUV-utilizing device. The connection chamber 21 is a rigid body, and made from, for example, metal. The connection chamber 21 is a vacuum housing, and the inside thereof is also reduced in pressure in order to suppress the attenuation of the EUV beam, which is similar to the inside of the chamber 11.

The internal space of the connection chamber 21 communicates with the chamber 11 through a window 17 which is a through hole formed in the wall of the chamber 11. In addition, the internal space of the connection chamber 21 communicates with the EUV-utilizing device (mask inspection device) 42 via a window 27 which is a through hole formed in the wall of the connection chamber 21. In FIG. 2, only a portion of the EUV-utilizing device 42 is shown. The EUV beam emitted from the plasma P in the discharge region D is introduced into the EUV-utilizing device 42 through the windows 17 and 27.

Debris DB is dissipated from the plasma P along with the EUV beam at high speed in various directions. The debris DB includes tin particles, which are plasma sources SA and SB, and material particles of the discharge electrodes EA and EB, which are sputtered upon the generation of the plasma P.

These debris DB are given large kinetic energies as the plasma P undergoes a process of shrinking and expanding. That is, the debris DB generated from the plasma P includes ions, neutral atoms, and electrons that move at high speed, and such debris DB may damage or contaminate reflective films of optical elements in the EUV-utilizing device 42 and degrade performance of the EUV-utilizing device 42 when the debris reaches the EUV-utilizing device 42.

Therefore, the debris reduction unit 3 for capturing the debris DB is provided in the connection chamber 21 so that the debris DB does not enter the EUV-utilizing device 42. The debris reduction unit 3 includes a static foil trap 24 in which the positions of the foils are fixed, and a rotary foil trap 22 in which the foils actively (dynamically) collide with the debris. The static foil trap 24 is provided between the rotary foil trap 22 and the EUV-utilizing device 42 on the optical path of the EUV beam traveling from the connection chamber 21 to the EUV-utilizing device 42. It should be noted that in the debris reduction unit 3, both the rotary foil trap 22 and the static foil trap 24 may be provided, or either one of them may be provided.

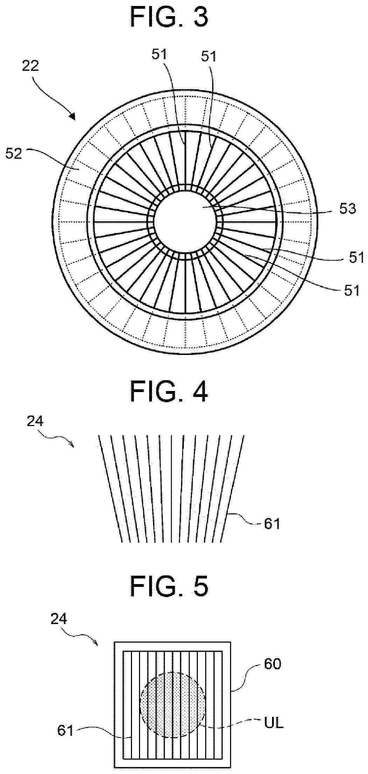

FIG. 3 is a front view illustrating an exemplary configuration of the rotary foil trap shown in FIG. 2.

In FIG. 3, the rotary foil trap 22 includes a plurality of foils (blades) 51, an outer ring 52, and a central hub (support member) 53. The outer ring 52 is concentric to the hub 53, and each of the blades 51 is disposed between the outer ring 52 and the hub 53. Each of the blades 51 is a thin film or a thin flat plate. Each of the blades 51 extends in a radial direction. The blades 51 are arranged at approximately equal angular spacing. The blades 51 are present on planes including the center axis JM of the hub 53. The material of the rotary foil trap 22 is, for example, a refractory metal such as tungsten and/or molybdenum.

The blades 51 of the rotary foil trap 22 are arranged in parallel to the direction of the EUV light traveling toward the window 27 such that the blades 51 do not block the EUV light traveling from the plasma P (lighting point) toward the window 27.

Specifically, as shown in FIG. 2, the rotary foil trap 22 in which the blades 51 are arranged on the planes including the center axis JM of the hub 53 is arranged such that the plasma P (lighting point) is present on an extension line of the center axis JM of the hub 53. With the exception of the hub 53 and the outer ring 52, the EUV beam is shielded only by the thickness of the blades 51, and the ratio of the EUV beam passing through the rotary foil trap 22 (also referred to as transmittance) can be maximized.

The hub 53 is connected to the rotation shaft JC of the motor (rotation drive device) MC, and the center axis JM of the hub 53 is coaxial with the center axis of the rotation shaft JC. The rotation shaft JC of the motor MC can be regarded as the rotation shaft of the rotary foil trap 22. The rotary foil trap 22 is driven and rotated by the motor MC, and the rotating blades 51 collide with the debris DB flying from the plasma P to capture the debris DB and prevent the debris DB from entering the EUV-utilizing device 42.

The rotary foil trap 22 is arranged in the connection chamber 21, whereas the motor MC is arranged outside the connection chamber 21. A through hole is formed on the wall of the connection chamber 21 such that the rotation shaft JC extends through the through hole. The gap between the rotating shaft JC and the wall of the connecting chamber 21 is sealed with a sealing member PC, e.g., a mechanical seal. The sealing member PC supports the rotation shaft JC of the motor MC such that the rotation shaft JC can rotate while maintaining the reduced-pressure atmosphere in the connecting chamber 21.

The rotary foil trap 22 is heated to a high temperature by radiation from the plasma P. In order to prevent overheating of the rotary foil trap 22, the rotation shaft JC may be made hollow to allow cooling water to flow therethrough, thereby cooling the rotary foil trap 22. In addition, since the motor MC itself generates heat at the time of rotating, the water cooling pipe 41 may be wound around the motor MC to remove heat. Water is supplied to the water cooling pipe 41, and the motor MC is cooled by heat exchange.

In order to reduce radiation from the plasma P to the rotary foil trap 22 and prevent overheating of the rotary foil trap 22, a heat shield plate 23 is disposed in the connection chamber 21. The heat shield plate 23 has an opening KA that has a suitable shape (for example, a circular shape) for extracting a part of the EUV beam emitted from the plasma P. Since the heat shield plate 23 is disposed in the vicinity of the plasma P, the heat shield plate 23 is made of a refractory material such as molybdenum or tungsten, for example.

The opening KA is provided at a position eccentric from the rotation axis JM of the rotary foil trap 22. The opening KA allows a part of the EUV beam emitted from the plasma P to travel through the heat shield plate 23 at a predetermined solid angle (with a predetermined inclination angle) relative to the rotational axis direction (left-right direction in FIG. 2) of the rotary foil trap 22.

The rotary foil trap 22 is arranged such that some of the blades 51 of the rotary foil trap 22 are positioned on the principal ray UL of the light beam (hereinafter, also referred to as EUV extraction light) of the EUV light that has passed through the opening KA of the heat shield plate 23. The EUV beam extracted from the opening KA of the heat shield plate 23 passes through the debris reduction unit 3 and is introduced into the EUV-utilizing device (mask inspection device) 42 via the window 27.

The rotary foil trap 22 captures the relatively low-speed debris DB among the debris DB dissipated from the plasma P, while the static foil trap 24 captures the high-speed debris DB among the debris DB dissipated from the plasma P that could not be captured by the rotary foil trap 22. As shown in FIG. 2, the static foil trap 24 is disposed on the principal ray UL of the EUV extraction light.

Further, the static foil trap 24 has a configuration corresponding to an area through which the EUV extraction light (i.e., the EUV light whose traveling direction is limited by the opening KA of the heat shield plate 23) passes.

FIG. 4 is a top view showing a configuration example of the static foil trap 24 shown in FIG. 2, and FIG. 5 is a cross-sectional view showing a configuration example of the static foil trap 24 of FIG. 2.

In FIGS. 4 and 5, the static foil trap 24 includes a plurality of foils (blades) 61 and a fixed frame (fixing member) 60 that supports the foils 61.

As shown in FIG. 5, the foils 61 are arranged at equal intervals in a cross section perpendicular to the principal ray UL of the EUV extraction light. The fixed frame 60 has, for example, a rectangular shape when viewed from the front. It should be noted that the outer shape of the fixed frame 60 may be any suitable shape other than the rectangular shape. As shown in FIG. 4, each of the foils 61 extends in the traveling direction of the EUV extraction light, and the foils 61 are radially arranged when viewed from a direction perpendicular to the direction of the principal ray UL.

The foils 61 of the static foil trap 24 finely divide the space in which the static foil trap 24 is disposed such that the foils 61 can reduce the conductance of the divided space and locally increase the pressure in the divided space (pressure in the static foil trap). Further, the pressure in the static foil trap 24 is increased by appropriately supplying gas to the static foil trap 24. In other words, in the connection chamber 21, the gas is localized in the static foil trap 24 to create a relatively high pressure area(s). Preferably, the gas to be supplied to the static foil trap 24 may have a high transmittance with respect to the EUV beam. For example, the gas to be supplied to the static foil trap 24 is a noble gas such as He or Ar, or hydrogen (H₂).

The high-speed debris DB that could not be captured by the rotary foil trap 22 is slowed down due to the increased likelihood of collision with the gases in the pressurized area of the static foil trap 24. In addition, the debris DB changes its traveling direction due to the collision with the gases. The static foil trap 24 captures the debris DB, which has thus been slowed down and changed the traveling direction, by means of the foils 61 and/or the fixed frame 60.

A cover member 25 is disposed in the connection chamber 21. The cover member 25 surrounds the rotary foil trap 22 and constitutes a foil trap cover device that prevents the debris DB captured by the rotary foil trap 22 from scattering inside the connecting chamber 21. The cover member 25 has a light entrance opening KI and light exit openings KOA and KOB. The light entrance opening KI is provided at a position where the EUV light entering the rotary foil trap 22 is not blocked. The light exit opening KOA is provided at a position where the EUV light that passes through the light entrance opening KI and the rotary foil trap 22 and enters the static foil trap 24 is not shielded. The light exit opening KOB is provided at a position where the EUV light that passes through the light entrance opening KI and the rotary foil trap 22 and enters the monitoring device 43 is not blocked.

At least a portion of the debris DB captured by the rotary foil trap 22 is moved radially (in the radial direction of the rotary foil trap 22) over the blades 51 of the rotary foil trap 22 by centrifugal force, detached from the ends of the blades 51, and adheres to the inner surface of the cover member 25.

The cover member 25 is heated by a heating unit (a cover heating unit, not illustrated in FIGS. 1 and 2) and/or secondary radiation from the heat shield plate 23 that has received the EUV radiation, and therefore this heating prevents the debris DB, which has adhered to the inner surface of the cover member 25, from being solidified, i.e., the debris BD that has adhered to the inner surface of the cover member 25 maintains a liquid phase. The debris DB that has adhered to the inner surface of the cover member 25 gathers at the lower portion (area) of the cover member 25 by gravitational force such that the debris DB is discharged from the lower portion of the cover member 25 to the outside of the cover member 25 via a discharge pipe 26 and becomes a waste raw material, and the waste raw material is received in the debris accommodation unit 4. Accordingly, the cover member 25 can prevent the debris DB separated from the end portions of the blades 51 of the rotary foil trap 22 from scattering inside the connecting chamber 21.

The debris accommodation unit 4 includes a debris container (debris storage) 31. The debris container 31 is disposed outside the connection chamber 21 and is attached to the connection chamber 21. The debris container 31 stores a substance SU including the debris DB and waste raw materials.

A through hole 37 is formed in the bottom wall of the connection chamber 21 to allow the inner space of the debris container 31 to communicate with the inner space of the connection chamber 21. The debris container 31 has a flange 32 at an upper portion thereof. The opening of the debris container 31 surrounded by the flange 32 is overlapped with the through hole 37 of the connection chamber 21. The debris container 31 is attached to the connection chamber 21 by fixing the flange 32 to the bottom wall of the connection chamber 21 with, for example, screws. The gap between the flange 32 and the bottom wall of the connection chamber 21 is sealed by a gasket 33. The heat shield plate 23 is disposed above the through hole 37 in an upright state. The discharge port of the discharge pipe 26 is disposed above the through hole 37. The debris container 31 is disposed at a position that allows the debris container 31 to catch the debris DB falling from the heat shield plate 23 and the debris DB falling from the discharge pipe 26.

The waste raw material discharged to the outside of the cover member 25 via the discharge pipe 26 falls in the direction of gravity and is received in the debris container 31 disposed below the connection chamber 21 (lower side in FIG. 2). On the other hand, a part of the debris DB dissipated in various directions from the plasma P enters the connection chamber 21 through the window 17 of the chamber 11 and is deposited on a surface of the heat shield plate 23 facing the window 17. The debris DB deposited on the heat shield plate 23 is melted by the radiation from the plasma P, and when the molten debris reaches a certain amount, it becomes a droplet and moves downward along the heat shield plate 23 by gravitational force. Then, the debris DB that has moved downward along the heat shield plate 23 leaves the heat shield plate 23 and falls downward from the connection chamber 21, so that the debris is received in the debris container 31.

In this way, the heat shield plate 23 limits the EUV radiation from the plasma P to the rotary foil trap 22 to prevent overheating of the rotary foil trap 22, and the opening KA of the heat shield plate 23 extracts a portion of the EUV beam emitted from the plasma P. In addition, the heat shield plate 23 reduces the debris DB traveling toward the rotary foil trap 22 as much as possible, thereby reducing a load on the rotary foil trap 22.

In the LDP type EUV light source device 1, a portion of the plasma source (tin) SA, SB supplied to the discharge unit (such as the discharge electrode EA, EB) may leak out. For example, a portion of the plasma source SA, SB may leak from the container CA, CB. The leaked plasma source (raw material) SA, SB does not contribute to the generation of the plasma P, and thus becomes a waste raw material. The plasma source SA, SB leaked from the discharging unit portion (discharge electrode EA, EB) is collected by an enclosing member (not shown).

In order to guide the plasma source SA, SB, which is collected as the waste raw material by the enclosing member, to the debris container 31 from the enclosing member, a receiving plate member (shovel) 18 is installed in the connecting chamber 21. The receiving plate member 18 is supported in an inclined posture such that the receiving plate member 18 extends from the window 17 to the through hole 37. The receiving plate member 18 is heated by a heating unit (heater, not shown) so that the plasma source SA, SB collected as the waste raw material is maintained at or above the melting point on the receiving plate member 18. The plasma source SA, SB collected as the waste raw material by the enclosing member and a part of the debris DB entering the connecting chamber 21 are guided to the receiving plate member 18 and fall into the debris container 31.

Since the majority of the debris DB is tin and the waste raw material is also tin, the debris container 31 may also be referred to as a tin collection container. A heater wire 34 as a heating material (heating unit) for heating the debris container 31 is wound around the debris container 31. The heating material may be embedded in the main body of the debris container 31.

As electric power is supplied to the heater wire 34 during operation of the EUV light source device 1, the inside of the debris container 31 is heated to a melting point of tin or to a higher temperature, and the tin accumulated in the inside of the debris container 31 is brought into a liquid phase.

The reason why tin in the debris container 31 is a liquid phase is that if the debris DB accumulated in the debris container 31 solidifies, the accumulated matter at a point where the debris DB easily falls grows like stalagmites in a limestone cave. If the accumulation of debris DB grows in a stalagmite shape, for example, the discharge pipe 26 of the cover member 25 is blocked (closed) by the debris DB, and the debris DB is accumulated in the cover member 25. If this occurs, at least a portion of the debris DB accumulated in the cover member 25 may contact the rotary foil trap 22, which would prevent the rotary foil trap 22 from rotating or damage the rotary foil trap 22.

Alternatively, a part of the light emission opening KOA, KOB provided in the cover member 25 may be blocked by the debris DB accumulated in the cover member 25, and a part of the EUV beam passing through the light emission opening KOA, KOB may be blocked.

Therefore, tin, which is a stored material in the debris container 31, is maintained in a liquid phase, such that tin can be flattened in the debris container 31, i.e., tin can be accumulated in the debris container 31 while avoiding growth such as stalagmite.

When the tin accumulated in the debris container 31 should be removed from the debris reduction device 23, the power supply to the heater wiring 34 is stopped, and the inside of the debris container 31 is stopped from being heated. As the temperature of the debris container 31 reaches the normal temperature (room temperature), tin stored in the debris storage container 31 is solidified. Then, the inside of the connecting chamber 21 is returned to the atmospheric pressure. Subsequently, the debris container 31 is removed from the connecting chamber 21, and a new debris container that contains no tin is attached to the connecting chamber 21.

Tin in the debris container 31 removed from the connecting chamber 21 is in a solid phase, but tin can be taken out from the debris container 31 by reheating the debris container 31 to re-bring tin in the debris container 31 into a liquid phase. The debris container 31 removed from the connecting chamber 21 and having no tin therein may be reused.

The monitoring device 43 for monitoring the EUV beam is arranged outside the connecting chamber 21. The monitoring device 43 is a detector that detects the EUV beam or a measuring device that measures the strength (optical intensity) of the EUV beam. An EUV light guide hole 28, which is a through hole through which the EUV light passes, is formed in the wall of the connecting chamber 21. A guide tube 29 through which the EUV light passes without leaking out of the connecting chamber 21 is provided between the EUV light guide hole 28 and the monitoring device 43.

The heat shield plate 23 has an opening KB of a suitable shape (for example, a circular shape) for extracting a part of the EUV beam emitted from the plasma P at a position different from the opening KA.

The monitoring device 43, the EUV light guide hole 28, and the guide tube 29 are disposed on an extension line of a straight line connecting the plasma P with the center of the opening KB. Therefore, a part of the EUV beam emitted from the plasma P sequentially passes through the window 17 of the chamber 11, the opening portion KB of the heat shield plate 23, the light entrance opening KI of the cover member 25, the gaps between the respective blades 51 of the rotary foil trap 22, the light exit opening KOB of the cover member 25, the EUV light guide hole 28 of the wall of the connecting chamber 21, and the hollow path of the guide tube 29, and reaches the monitoring device 43. In this way, the EUV beam can be monitored by the monitoring device 43.

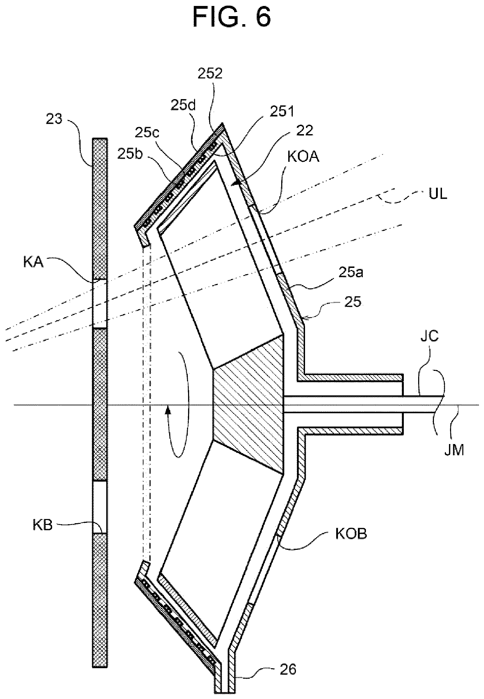

Hereinafter, the cover member 25 according to this embodiment will be described in detail. FIG. 6 is a schematic view illustrating a configuration of the cover member 25.

As shown in FIG. 6, the cover member 25 includes a cover body 25a that surrounds an outer peripheral portion of the rotary foil trap 22, and cover heaters (heating sub-units) 25b that are provided on at least some areas on a second surface 252 of the cover body 25a. The second surface 252 is opposite to a first surface 251 of the cover body 25a. Each of the cover heaters 25b may be, for example, a sheath heater to which electric power is supplied from a power supply unit (not shown).

The first surface 251 is an inner surface of the cover body 25a and faces the blades 51 in the centrifugal force direction of the rotary foil trap 22. The first surface 251 is the surface to which the debris DB captured by the rotary foil trap 22 and separated from the ends of the blades 51 by the centrifugal force generated during the rotary operation of the rotary foil trap 22 adheres.

The second surface 252 is an outer surface of the cover body 25a and is exposed to the plasma P.

The cover heaters 25b are provided to maintain the temperature of the first surface 251 of the cover body 25a at or above the melting point of debris (tin). Therefore, the cover heaters 25b are disposed on the cover body 25a such that the cover heaters 25b can appropriately heat the first surface 251.

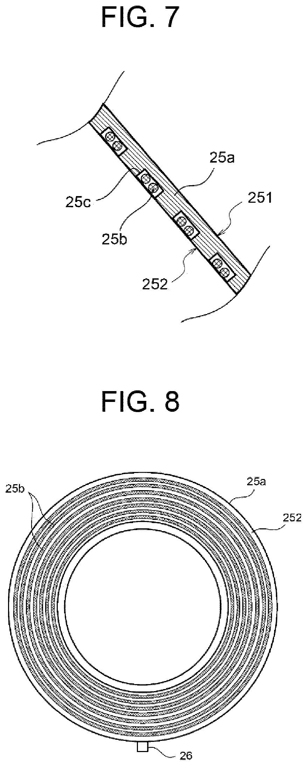

For example, as shown in FIG. 7, the cover heaters 25b make plural pairs of cover heaters 25b, and each pair of cover heaters 25b are disposed in each of groove-shaped heater installation portions 25c formed on the second surface 252 of the cover body 25a. Accordingly, the cover heaters 25b are not exposed to the first surface 251 of the cover body 25a and can be disposed at positions close to the first surface 251. Further, for example, as shown in FIG. 8, the cover heaters 25b can be arranged concentrically on the second surface 252 of the cover body 25a. In this configuration, a power supply amount to the cover heaters 25b may be controlled by using a common wiring, or the power supply amount may be individually controlled by using a plurality of individual wiring. It should be noted that the arrangement of the cover heaters 25b is not limited to the concentric arrangement as shown in FIG. 8, e.g., a single cover heater 25b may be arranged in a spiral shape.

The reason why the cover heaters 25b are not exposed to the first surface 251, which is the inner surface of the cover body 25a, and are provided on the second surface 252, which is the outer surface of the cover body 25a, will be described below.

If the cover heaters 25b are exposed on the first surface 251, which is the inner surface of the cover body 25a, tin (debris) separated from the rotary foil trap 22 is deposited on the cover heaters 25a, which are supplied with power and have a high temperature. Liquid tin has the property of chemically reacting with a solid metal to dissolve the solid metal. Since the reaction rate (dissolution rate) increases with increasing temperature, the cover heaters 25b are liable to be dissolved (corroded) by the tin liquefied upon heating of the cover heaters 25b. Thus, the cover heaters 25b are provided on the second surface 252, which is the outer surface of the cover body 25a, such that the cover heaters 25b are not in direct contact with the liquid tin.

However, if the cover heaters 25b are only provided on the outer surface of the cover body 25a, debris (tin) also reaches some portions of the cover heaters 25b as the EUV light source device is operated to some extent. Then, problems such as disconnection due to erosion occur.

As shown in FIG. 2, the heat shield plate 23 is disposed between the plasma P and the rotary foil trap 22 and between the plasma P and the cover member 25 that surrounds the rotary foil trap 22. Part of the EUV beam emitted from the plasma P passes through the window 17, which is a through hole formed in the wall of the chamber 11, and reaches the heat shield plate 23. Then, among the EUV beams that have reached the heat shield plate 23, the EUV beams that have passed through the openings KA and KB formed in the heat shield plate 23 reach the rotary foil trap 22.

Therefore, most of the debris dissipated from the plasma P is deposited on the heat shield plate 23 as the debris collides with the surface of the heat shield plate 23 facing the plasma P, except for the debris passing through the openings KA and KB of the heat shield plate 23.

Most of the debris that has passed through the openings KA and KB reaches the foils (blades) 51 of the rotary foil trap 22 and is captured by the blades 51. However, some portions of the debris that have passed through the openings KA and KB may reach an area other than the blades 51 of the rotary foil trap 22, e.g., the outer surface of the cover member 25.

As mentioned above, liquid tin has the property of chemically reacting with a solid metal to melt the solid metal. Therefore, if the cover heaters 25b are only provided on the outer surface of the cover body 25a, a quantity of debris (tin) reaching the surfaces of the cover heaters 25b is gradually increased during the operation of the EUV light source device 1, and the cover heaters 25b which are supplied with power and have a high temperature are corroded by tin.

To avoid this, the inventor placed a corrosion-resistant film over the surfaces of the cover heaters 25b, and investigated the occurrence of defects in the cover heaters 25b. The corrosion-resistant film was a titanium nitride (TiN) film. It should be noted that material of the corrosion-resistant film is not limited to TiN, but the material of the corrosion-resistant film may be tungsten, molybdenum or silicon carbide (SiC), or the corrosion-resistant film may be an oxide film.

When the corrosion-resistant film was applied over the surfaces of the cover heaters 25b, it was possible to suppress the occurrence of a defect in the cover heaters 25b to some extent as compared with a case where the corrosion-resistant film was not applied. However, the life of the cover heaters 25b (the time until a defect caused by corrosion derived from tin occurs) could not be brought close to the original life of the cover heaters 25b (the time until a defect caused by reasons not related to corrosion derived from tin occurs). Thus, the effectiveness was limited.

In this embodiment, therefore, as shown in FIG. 6, the cover heaters 25b disposed on the second surface 252 which is the outer surface of the cover body 25a are covered with a shielding member 25d which is a member for protecting the heating unit (cover heaters).

The shielding member 25d shields the cover heaters 25b from debris and prevents tin flying from the plasma P and tin floating in the connection chamber 21 from reaching the surfaces of the cover heaters 25b. Further, as the shielding member 25d is configured from a plate-like member having a certain thickness, it takes time until the liquid tin reaches the cover heaters 25b through the shielding member 25d even if the shielding member 25d is corroded by the liquid tin. Thus, it is possible to extend the life of the cover heaters 25b and the life of the cover member 25.

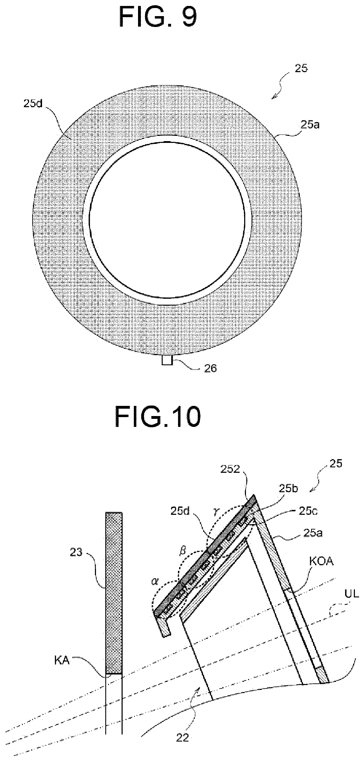

For example, as shown in FIG. 9 in which the cover member 25 is viewed from the plasma P, the shielding member 25d may be provided on the entire second surface 252 of the cover body 25a.

The shielding member 25d is attached to the cover body 25a by welding (for example, laser welding or the like), and the cover heaters 25b are completely sealed by the cover body 25a and the shielding member 25d.

For example, it is possible to attach the shielding member 25d to the cover body 25a by screwing. This configuration can improve the life of the cover heaters 25b as compared with a configuration in which the shielding member 25d is not attached, but eventually the failure of the cover heaters 25b occurs. This is because tin (debris) enters from a small gap between the cover body 25a and the shielding member 25d attached to the cover body 25a by screwing, and the tin contacts and corrodes the cover heaters 25b. Liquefied tin is less viscous and therefore can penetrate even into small gaps.

Therefore, in order to prevent the above-described intrusion of tin and prevent the cover heaters 25b from being corroded by tin, it is preferable to attach the shielding member 25d to the cover body 25a by welding.

The welding process is, for example, laser-welding or electron-beam welding that can perform local heating and can connect the shielding member 25d to the cover body 25a without damaging the cover heaters 25b.

The cover body 25a and the shielding member 25d are preferably made of the same material. By making both the cover body 25a and the shielding member 25d from the same material, it is possible for the cover body 25a and the shielding member 25d to have the same thermal expansion coefficient, i.e., it is possible to eliminate the influence of undesired stress caused by the difference in the thermal expansion coefficient, and it is also possible to suppress the occurrence of defects such as breakage. The cover body 25a and the shielding member 25d may be made of, for example, stainless steel in view of heat resistance, workability (processability), and cost efficiency.

The front surface of the shielding member 25d is heated by the radiation from the plasma P that faces the shielding member 25d. Further, the back surface of the shielding member 25d is heated by the cover heaters 25b, and therefore, depending on the thickness and material of the shielding member 25d, heat from the cover heaters 25b may be transmitted to the front surface of the shielding member 25d. During operation of the EUV light source device 1, the front surface of the shielding member 25d becomes a high temperature.

The debris flying from the plasma P and the debris floating in the connecting chamber 21 adhere to at least some areas on the front surface of the shielding member 25d.

That is, the shielding member 25d may be corroded due to adhesion of debris (tin) to the front surface of the shielding member 25d at a high temperature under certain conditions. To avoid this, at least a part of the exposed surface of the shielding member 25d may be provided with a corrosion-resistant film having corrosion resistance against debris. The corrosion-resistant film is, for example, a titanium nitride (TiN) film. The material of the corrosion-resistant film is not limited to TiN, i.e., the material of the corrosion-resistant film may be tungsten, molybdenum or silicon carbide (SiC), or the corrosion-resistant film may be an oxide film. The corrosion-resistant film may be formed by sputtering or by plasma CVD (Chemical Vapor Deposition).

Next, the control of power supply to the cover heaters 25b will be described.

FIG. 10 illustrates a part of a cross section of the cover member 25. The cover body 25a is directly heated by the cover heaters 25b and is also heated by radiation from the plasma P through the shielding member 25d. The heating by the radiation from the plasma P is not uniformly performed, and the degree of heating varies depending on the distance from the plasma P.

As shown in FIG. 10, when the second surface 252 of the cover body 25a is divided into three regions α, β, and γ in accordance with the distance from the plasma P, the degree of heating by the plasma P decreases in the order of the region α, the region β, and the region γ in accordance with the distance from the plasma P.

Therefore, for example, when the heating by the cover heaters 25b is not performed, the temperature of the cover body 25a becomes the highest in the region α, which is closest to the plasma P, and the temperature of the cover body 25a becomes the lowest in the region γ, which is farthest from the plasma P, due to the non-uniform heating by the radiation from the plasma P. Since the cover body 25a and the shielding member 25d are made of a stainless steel having a low thermal conductivity, the above-mentioned temperature unevenness due to the heating unevenness tends to occur.

Therefore, if the heating distribution by the cover heaters 25b is uniform, the temperature of the region α may become too high and/or the temperature of the region γ may become too low.

That is, if the amount of power supplied to the cover heaters 25b in all the regions α, β, and γ is uniformly controlled in accordance with the degree of heating by radiation from the plasma P in the region α, the amount of power supplied to the cover heaters 25b provided in the region γ may be insufficient, and the temperature of the region γ may not be a temperature at which debris (tin) can be sufficiently liquefied. On the other hand, if the amount of power supplied to the cover heaters 25b in all the regions is uniformly controlled in accordance with the degree of heating by radiation from the plasma P in the region γ, the amount of power supplied to the cover heaters 25b provided in the region α becomes excessive, and the temperature of the region α becomes too high, so that the shielding member 25d made of stainless steel and debris (tin) easily react with each other.

To avoid this, the amounts of power supply to the cover heaters 25b arranged concentrically on the front surface of the second surface 252 of the cover body 25a as shown in FIG. 8 are individually controlled for the respective regions α, β, and γ in accordance with the distance from the plasma P as shown in FIG. 10.

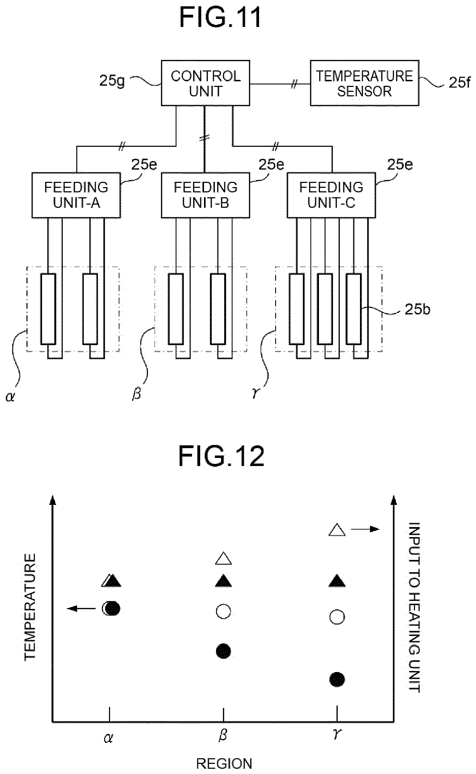

Specifically, as shown in FIG. 11, a group of cover heaters 25b disposed in the region α, another group of cover heaters 25b disposed in the region β, and still another group of cover heaters 25b disposed in the region γ use three independent power feed lines, respectively, such that the three regions α, β, and γ are individually controlled.

As shown in FIG. 11, the foil trap cover device according to this embodiment includes a plurality of power supply units 25e (feeding units A to C) for supplying electric power to the cover heaters 25b in the three regions α, β, and γ, respectively, a temperature sensor (temperature detection unit) 25f for detecting a plurality of temperature of the cover body 25a for the respective regions α, β, and γ, and a control unit 25g for controlling the amounts of power supply from the three power supply units 25e to the three groups of cover heaters, respectively, based on the temperatures detected by the temperature sensor 25f.

In this embodiment, the group of cover heaters 25b disposed in the region α are supplied with power from the feeding unit A, the group of cover heaters 25b disposed in the region β are supplied with power from the feeding unit B, and the group of cover heaters 25b disposed in the region γ are supplied with power from the feeding C.

The temperature sensor 25f is provided on the cover member 25. It should be noted that illustration of the temperature sensor 25f is omitted in FIG. 10.

The control unit 25g individually controls the feeding units A to C so that the temperatures of the cover body 25a of the respective regions α, β, and γ are equal to or higher than the melting point of the high-temperature plasma raw material (tin) based on the temperatures detected by the temperature sensor 25f.

FIG. 12 is a conceptual diagram of individual control of the cover heaters 25b.

In FIG. 12, a circle mark (white circle, black circle) indicates the temperature of the cover body 25a, and a triangle mark (white triangle, black triangle) indicates the input to the heating unit (the amount of power supply to the respective group of cover heaters 25b). When the amounts of power supplied to the cover heaters 25b of the three regions α, β, and γ are equal to each other as indicated by the three black triangle marks, the temperature becomes the highest in the region α closest to the plasma P, and decreases in the order of the region β and the region γ as the distance from the plasma P gradually increases as indicated by the black circle marks.

On the other hand, when the amounts of power supplied to the cover heaters 25b are increased in the order of the region α, the region β, and the region γ as indicated by the there white triangle marks, the temperature of the regions α, β, and γ becomes substantially uniform as indicated by the three white circle marks.

As described above, the arrangement area of the cover heaters 25b is divided into the three regions α, β, and γ according to the distance from the plasma P, and the amounts of power supplied to the cover heaters 25b are controlled for the three regionsα, β, and γ, respectively, whereby the temperatures of the respective regions α, β, and γ can be maintained at a desired temperature.

The desired temperature is a temperature at least equal to or higher than the melting point of the high-temperature plasma raw material (tin) and the temperature should not be too high. For example, the desired temperature may be between 300 degrees C and 500 degrees C. The temperature of the three regions α, β, and γ need not be the same, but may be within a desired temperature range.

In this embodiment, the second surface 252 of the cover body 25a, which is the arrangement area of the cover heaters 25b arranged concentrically, is divided into the three regions α, β, and γ, but the present invention is not limited thereto, and the second surface 252 may be divided into a suitable number of regions to control the amounts of power supply to the cover heaters 25b arranged in the respective regions.

As described above, the foil trap cover device according to this embodiment includes the cover member 25 that surrounds the outer peripheral portion of the rotary foil trap 22 and collects debris scattered from the rotary foil trap 22. The rotary foil trap 22 has a plurality of rotating foils (blades) 51 which are arranged in the vicinity of the plasma P generated by the light source unit (plasma generating unit) 2, and allows light emitted from the plasma P to pass through the rotary foil trap 22 while capturing debris generated from the plasma P.

The cover member 25 includes the cover body 25a that surrounds an outer peripheral portion of the rotary foil trap 22, the cover heaters 25b that are provided on at least a part of the second surface 252 of the cover body 25a, which is exposed to the plasma P and is opposite to the first surface 251 that faces the blades 51, and heats the cover body 25a, and the shielding member 25d that covers the cover heaters 25b and shields the cover heaters 25b from debris. The shielding member 25d is made from a corrosion resistant material having higher corrosion resistance to debris than the cover heaters 25b.

As described above, the cover heaters 25b provided on the second surface 252 of the cover main body 252 facing the plasma P are covered with the shielding member 25d having the corrosion resistance higher than that of the cover heaters 25b with respect to the debris, whereby it is possible to appropriately suppress the occurrence of the defect of the cover heaters 25b caused by the corrosion derived from the tin. Therefore, the life of the cover heaters 25b (time until a defect caused by corrosion derived from tin occurs) can be brought close to the original life of the cover heaters 25b (the time until a defect caused by reasons not related to corrosion derived from tin occurs).

Since the shielding member 25d is attached to the second surface 252 of the cover body 25a by welding, the cover heaters 25b and the heater installation portions 25c can be sealed by the cover body 25a and the shielding member 25d. Therefore, it is possible to reliably prevent debris (tin) from adhering to the cover heaters 25b at a high temperature, and it is possible to appropriately suppress corrosion of the cover heaters 25b caused by tin.

The cover body 25a and the shielding member 25d are preferably made of the same material. In this configuration, it is possible to suppress the stress concentration caused by the difference in the thermal expansion coefficient between the cover body 25a and the shielding member 25d.

For example, the cover body 25a and the shielding member 25d may be made of stainless steel in view of heat resistance, workability, and cost efficiency. Considering the corrosion resistance against debris, it is conceivable that the cover body 25a and the shielding member 25d are made of molybdenum, but molybdenum is more expensive than stainless steel and is more difficult to process, i.e., use of molybdenum is costly.

Since stainless steel is a material having a low thermal conductivity, temperature unevenness tends to occur due to a difference in the degree of heating according to the distance from the plasma P.

In this embodiment, the cover heating unit 25b is constituted by a plurality of cover heating sub-units (cover heaters) 25b that allow individual controlling to the power supply amounts, the temperatures of the cover body 25a are detected for the respective regions which correspond to the three groups of cover heaters 25b, and the three groups of cover heaters 25b are individually controlled based on the detected temperatures. Therefore, the temperature of the cover body 25a in each of the three regions can be controlled to a desired temperature. Specifically, the temperature of the cover body 25a located far from the plasma P can be appropriately set to be equal to or higher than the melting point of tin. In addition, the temperature of the cover body 25a located close to the plasma P can be controlled so as not to become too high.

Further, by arranging the cover heaters 25b concentrically on the second surface 252 of the cover body 25a around the axis passing through the plasma P, it is possible to provide the cover heaters 25b independently in the regions on the second surface 252 which are defined according to the distance from the plasma P. Therefore, it is possible to easily and appropriately suppress the temperature unevenness caused by the difference in the degree of heating according to the distance from the plasma P.

As described above, in the foil trap cover device according to this embodiment, the heating sub-units (cover heaters 25b) for heating the cover body 25a and the debris are prevented from contacting each other, and thus it is possible to appropriately prevent the heating sub-units from being corroded by the debris and the occurrence of defects such as disconnection caused by the corrosion of the heating sub-units.

### Modifications

In the above-described embodiment, the shielding member 25d is provided on the entire surface of the second surface 252 of the cover body 25a as shown in FIG. 9, but the present invention is not limited thereto, i.e., the shielding member 25d may cover at least the exposed surfaces of the cover heaters 25b.

In the above-described embodiment, the cover heaters 25b are disposed in the groove-shaped heater installation portions 25c formed in the cover body 25a, but the cover heaters 25b may be press-fitted to the cover body 25a, or may be installed on the second surface 252 of the cover main body without providing the heater installation portions 25c.

In the above-described embodiment, when the cover body 25a and the shielding member 25d are made of the same material, they may be manufactured in the form of a single member. That is, the cover heaters 25b may be built in the cover member 25.

In the above-described embodiment, the laser beam is used as an energy beam for irradiating a high-temperature plasma source, but an ion beam, an electron beam, or the like may be used instead of the laser beam.

In the above-described embodiment, the present invention is applied to the DPP type EUV light source device, but the present invention is also applicable to the LPP type EUV light source device. LPP method is a method in which a target material is irradiated with a driver laser for plasma generation, and the target material is excited to generate plasma.

In the above-described embodiment, the light source device having the rotary foil trap 22 is described as an EUV light source device, but the light source device may be a VUV (vacuum-ultraviolet) light source device for extracting VUV light or an X-ray generating device for extracting X-rays.

When the light source device functions as a VUV light source device, the VUV light source device can also be used as a light source for surface-modification of a substrate, a light source for ozone generation, and a light source for substrate bonding.

On the other hand, when the light source device functions as an X-ray generating device, the X-ray generating device can be used in applications such as chest X-ray photography, dental X-ray photography, and CT (Computer Tomogram) in the medical field. When the X-ray generating device is used in the industrial field, it can be used in such applications as non-destructive inspection and tomographic non-destructive inspection for observing the inside of the material such as structures and welds. When the X-ray generating device is used in research fields, it can be used in such applications as X-ray analysis for analyzing the crystal structure of a substance, and X-ray spectroscopy for analyzing constituent elements of a substance (fluorescence X-ray analysis).

While specific embodiments have been described above, such embodiments are merely illustrative and are not intended to limit the scope of the invention. The device, apparatus and methods described herein may be embodied in other forms than those described above. Further, omissions, substitutions, and changes may be made to the above-described embodiments as appropriate without departing from the scope of the present invention. Such omissions, substitutions, and changes are included in the scope of the claims and their equivalents, and fall within the scope of the present invention.

### REFERENCE NUMERALS AND SYMBOLS

1: Extreme ultraviolet light source device (EUV light source device)
2: Light source unit
3: Debris reduction part
4: Debris accommodation unit
11: Chamber
21: Connection chamber
22: Rotary foil trap
23: Heat shield plate
24: Static foil trap
25: Cover member
25a: Cover body
25b: Cover heating unit
25c: Heater installation part
25d: Shielding member
31: Debris container
51: Foil
52: Outer ring
53: Hub
DB: Debris

## Claims

1. A foil trap cover device configured to surround an outer peripheral portion of a rotary foil trap and collect debris scattered from the rotary foil trap, the rotary foil trap arranged near a plasma generated by a plasma generating unit, the rotary foil trap having a plurality of rotatable foils and configured to allow light emitted from the plasma to pass through the rotary foil trap and configured to capture debris generated from the plasma,
the foil trap cover device comprising:
a cover body configured to surround the outer peripheral portion of the rotary foil trap, the cover body having a first surface, which faces the foils, and a second surface, which is opposite to the first surface and faces the plasma;
a cover heating unit provided on at least a portion of the second surface of the cover body and configured to heat the cover body; and
a heating unit protecting member configured to cover the cover heating unit.

2. The foil trap cover device according to claim 1, wherein the heating unit protecting member is made from a corrosion resistant material having a higher corrosion resistance to the debris than the cover heating unit.

3. The foil trap cover device according to claim 1 or 2, wherein the cover heating unit is sealed by the cover body and the heating unit protecting member.

4. The foil trap cover device according to claim 1 or 2, wherein the heating unit protecting member is attached to the second surface of the cover body by welding.

5. The foil trap cover device according to claim 1 or 2, wherein a corrosion resistant film having corrosion resistance against the debris is provided on at least a part of an exposed surface of the heating unit protecting member.

6. The foil trap cover device according to claim 5, wherein the corrosion resistant film is a film made of at least one of tungsten, molybdenum, titanium nitride, and silicon carbide, or an oxide film.

7. The foil trap cover device according to any one of claims 1, 2 and 6, wherein the cover body and the heating unit protecting member are made of a same material.

8. The foil trap cover device according to any one of claims 1, 2 and 6, wherein the cover body and the heating unit protecting member are made of stainless steel.

9. The foil trap cover device according to any one of claims 1 to 8, wherein the cover heating unit has plural groups of cover heating sub-units such that an amount of electric power to be supplied to each of the plural groups of cover heating sub-units can individually be controlled, and the plural groups of cover heating sub-units are located in a plurality of regions, respectively, and
the foil trap cover device includes:
a temperature detecting unit configured to detect a plurality of temperature of the cover body for the plurality of regions, respectively; and
a control unit configured to control the amount of electric power to be supplied to each of the plural groups of cover heating sub-units, based on the plurality of temperature detected by the temperature detecting unit, so that the plurality of temperature of the cover body becomes equal to or higher than a melting point of a raw material used to generate the plasma.

10. The foil trap cover device according to claim 9, wherein the plurality of regions are defined by dividing the second surface according to a distance from the plasma, and
the plural groups of cover heating sub-units are independent from each other depending upon the plurality of regions.

11. A debris reduction device comprising:
the foil trap cover device recited in any one of claims 1 to 10; and
the rotary foil trap.

12. An extreme ultraviolet light source device comprising:
the debris reduction device recited in claim 11; and
the plasma generating unit configured to generate a plasma that emits extreme ultraviolet light.
